# EUROPEAN PATENT APPLICATION

(11) **EP 4 155 243 A1**
(43) Date of publication of application: **29.03.2023**
(21) Application number: 21808078.6
(22) Date of filing: 18.05.2021
(51) Int. Cl.: B65G 49/07, H01L 21/677, B25J 15/06

(54) **CONVEYANCE DEVICE**

(30) Priority: 21.05.2020 JP 2020089035
(71) Applicant: Harmotec Co., Ltd., Kofu City Yamanashi 400-0851 (JP)
(72) Inventor: IWASAKA Hitoshi, Kofu City, Yamanashi 400-0851 (JP); TANAKA Hidemitsu, Kofu City, Yamanashi 400-0851 (JP); TOKUNAGA Hideyuki, Kofu City, Yamanashi 400-0851 (JP); KOSHIISHI Katsuhiro, Kofu City, Yamanashi 400-0851 (JP); KASAI Yuji, Kofu City, Yamanashi 400-0851 (JP); IWASAKA Naonari, Kofu City, Yamanashi 400-0851 (JP)
(74) Representative: Haseltine Lake Kempner LLP
(86) International application number: PCT/JP2021/018765
(87) International publication number: WO 2021/235428

(57) **Abstract**

A conveyance device according to an embodiment of the present invention comprises a plate-shaped main body that faces a plate-shaped object to be conveyed, a plurality of recesses formed in the plate-shaped main body to face an outer circumferential portion of the plate-shaped object to be conveyed, a plurality of discharge channels formed inside the main body, and a plurality of movement restriction members formed on the main body to contact with and to restrict lateral movement of the plate-shaped object to be conveyed. One each of the plurality of discharge channels is connected to one each of the plurality of recesses, and a swirling flow is formed in the plurality of recesses by fluid supplied from the plurality of connected discharge channels. In each of the plurality of recesses, a portion of an opening not covered by the plate-shaped object to be conveyed is covered by one of the plurality of movement restriction members.

## Description

### TECHNICAL FIELD

The present invention relates to a conveyance device.

### BACKGROUND ART

Conventionally, devices that convey objects in a non-contact manner have been used to convey semiconductor wafers. For example, Patent Document 1 discloses a device that conveys semiconductor wafers in a non-contact manner by utilizing Bernoulli's principle. The device disclosed in Patent Document 1 has a cylindrical chamber that opens at an underside, generates a swirling flow in the cylindrical chamber, and applies suction to semiconductor wafers under a negative pressure generated at the center of the swirling flow. The device enables non-contact transfer of semiconductor wafers by maintaining a consistent distance between the device and the semiconductor wafers by fluid flowing out of the cylindrical chamber.

### PRIOR ART DOCUMENT

### PATENT DOCUMENT

Patent Document 1: Japanese Unexamined Patent Application No. 2005-51260

### SUMMARY OF THE INVENTION

### PROBLEM TO BE SOLVED BY THE INVENTION

The present invention has been made in view of the above technology, and the purpose of the present invention is to substantially reduce damage to a surface of plate-shaped objects to be conveyed.

### MEANS FOR SOLVING THE PROBLEM

To solve the problem described above, the present invention provides a conveyance device that applies suction to and conveys_a plate-shaped object to be conveyed, the device comprising: a plate-shaped main body that faces the plate-shaped object to be conveyed; a plurality of recesses formed in the plate-shaped main body to face an outer circumferential portion of the plate-shaped object to be conveyed; a plurality of discharge channels formed inside the plate-shaped main body; and, a plurality of movement restriction members formed on the main body to contact with and restrict lateral movement of the plate-shaped object to be conveyed; wherein, one each of the plurality of discharge channels is connected to one each of the plurality of recesses, and a swirling flow is formed in the plurality of recesses with fluid supplied from the plurality of connected discharge channels; and, in each of the plurality of recesses, a portion of an opening not covered by the plate-shaped object to be conveyed is covered by one of the plurality of movement restriction members.

In a preferred embodiment of the above-described conveyance device, the plurality of recesses are formed at each of one end and another end of the main body in opposing relation to each other; and, the plurality of discharge channels are formed so that fluid flowing out of the plurality of recesses connected to the plurality of discharge channels flows in a direction from outside to inside of the plate-shaped object to be conveyed.

In a further preferred embodiment of the above-described conveyance device, the plurality of movement restriction members each forms an outlet path between the plate-shaped main body such that fluid flowing out of any one of the plurality of recesses whose opening is partially covered by any one of the plurality of movement restriction members flows in the direction from the inside to the outside of the plate-shaped object to be conveyed.

### EFFECTS OF THE INVENTION

According to the present invention, damage to a surface of a plate-shaped object to be conveyed can be substantially reduced.

### BRIEF EXPLANATION OF THE DRAWINGS

[FIG. 1] Figure 1 is a plan view of wafer conveyance hand 1.
[FIG. 2] Figure 2 is a bottom view of wafer conveyance hand 1.
[FIG. 3] Figure 3 is a side view of wafer conveyance hand 1.
[FIG. 4] Figure 4 is a plan view of paddle 11.
[FIG. 5] Figure 5 is a bottom view of paddle 11.
[FIG. 6] Figure 6 is a top view of a leading edge of arm 111A.
[FIG. 7] Figure 7 is a bottom view of a leading edge of arm 111A with sealing member 12 attached.
[FIG. 8] Figure 8 is a vertical cross section view of concave part 15 shown in Figure 7.
[FIG. 9] Figure 9 is a plan view of guide member 14.
[FIG. 10] Figure 10 is a bottom view of guide member 14.
[FIG. 11] Figure 11 is a side view of guide member 14.
[FIG. 12] Figure 12 is an oblique view of guide member 14.
[FIG. 13] Figure 13 is a bottom view of the leading edge of arm 111A shown in Figure 2.
[FIG. 14] Figure 14 is a side view of the leading edge of arm 111A in the direction indicated by arrow A2 shown in Figure 13.
[FIG. 15] Figure 15 is a side view of the leading edge of arm 111A in the direction indicated by arrow A3 shown in Figure 13.
[FIG. 16] Figure 16 illustrates air flow from concave part 15.
[FIG. 17] Figure 17 is a plan view of wafer conveyance hand 2.
[FIG. 18] Figure 18 is a bottom view of wafer conveyance hand 2.
[FIG. 19] Figure 19 is a side view of wafer conveyance hand 2.
[FIG. 20] Figure 20 is a plan view of paddle 21.
[FIG. 21] Figure 21 is a bottom view of paddle 21.
[FIG. 22] Figure 22 is a top view of a leading edge of paddle 21.
[FIG. 23] Figure 23 is a bottom view of paddle 21 with sealing member 22 attached.
[FIG. 24] Figure 24 is a vertical cross section view of concave part 26 shown in Figure 23.
[FIG. 25] Figure 25 is a plan view of guide member 23.
[FIG. 26] Figure 26 is a bottom view of guide member 23.
[FIG. 27] Figure 27 is a side view of guide member 23.
[FIG. 28] Figure 28 is an oblique view of guide member 23.
[FIG. 29] Figure 29 is a bottom view of the leading edge of paddle 21 shown in Figure 18.
[FIG. 30] Figure 30 is a side view of the leading edge of paddle 21 in the direction indicated by arrow A5 shown in Figure 29.
[FIG. 31] Figure 31 is a side view of the leading edge of paddle 21 in the direction indicated by arrow A6 shown in Figure 18.
[FIG. 32] Figure 32 illustrates air flow from concave part 26.
[FIG. 33] Figure 33 is a plan view of wafer conveyance hand 3.
[FIG. 34] Figure 34 is a bottom view of wafer conveyance hand 3.
[FIG. 35] Figure 35 shows a variation in shape of through hole 113 or 211.
[FIG. 36] Figure 36 shows a variation in shape of through hole 113 or 211.
[FIG. 37] Figure 37 shows a variation in shape of through hole 113 or 211.
[FIG. 38] Figure 38 is a bottom view of an example of cushioning member 41.
[FIG. 39] Figure 39 is a side view of an example of cushioning member 41.

### MODES FOR CARRYING OUT THE INVENTION

### 1. First Embodiment

Wafer conveyance hand 1 of the first embodiment of the present invention is described below with reference to the drawings.

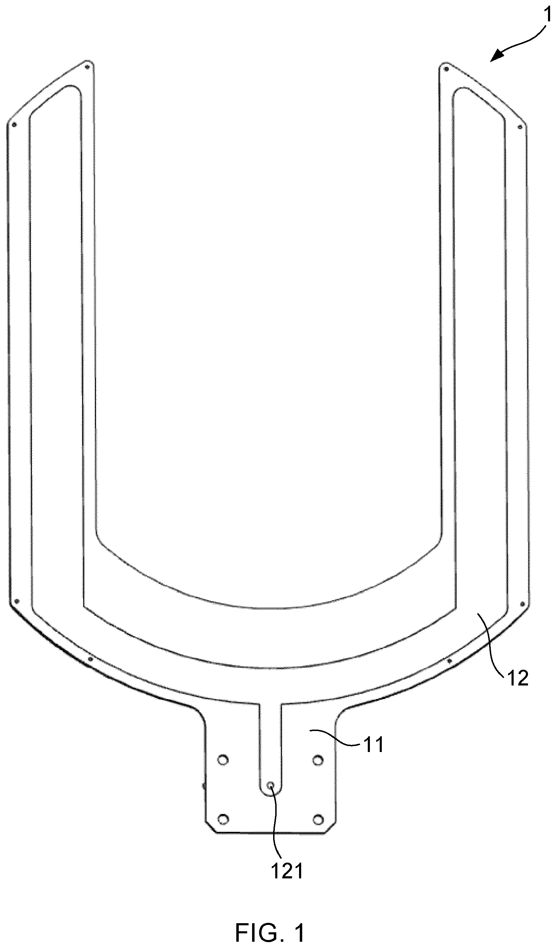

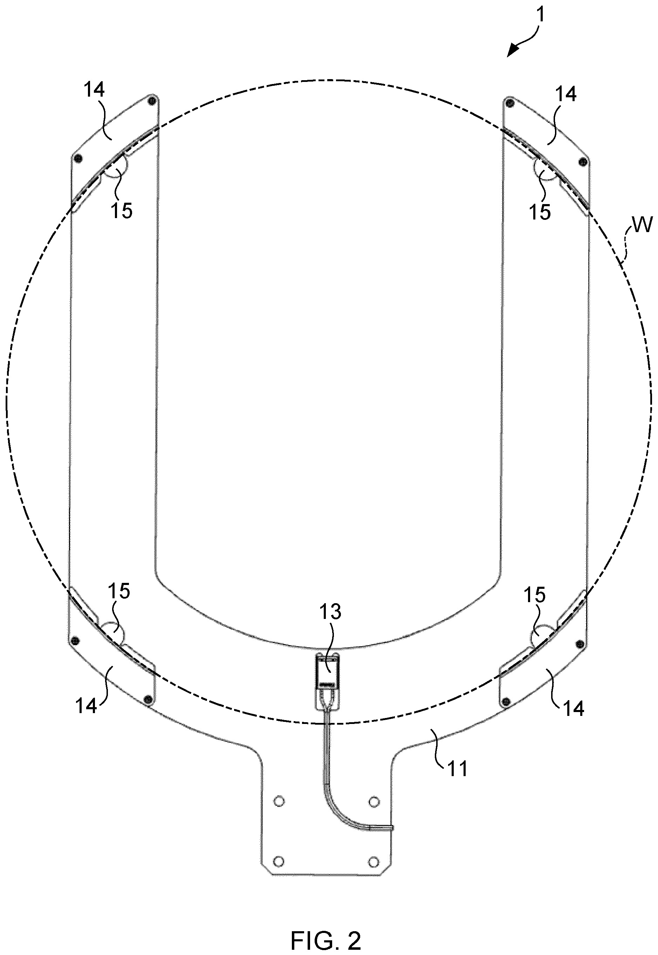

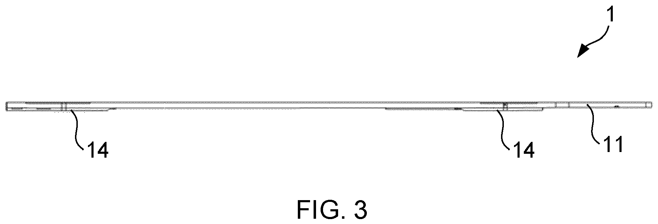

Figure 1 is a plan view of wafer conveyance hand 1. Figure 2 is a bottom view of wafer conveyance hand 1. Figure 3 is a side view of wafer conveyance hand 1. Wafer conveyance hand 1 shown in these figures is a device designed to apply suction to and convey a TAIKO wafer W by utilizing Bernoulli's law. TAIKO is a registered trademark in Japan. TAIKO wafer W is formed by grinding only an inside of a wafer material, and leaving an outer periphery (about 3 mm). In the following description, TAIKO wafer W is simply referred to as "wafer W." In use, wafer conveyance hand 1 is mounted to an end of a robot arm.

Wafer conveyance hand 1 comprises paddle 11, sealing member 12, sensor 13, and four guide members 14, which are described below.

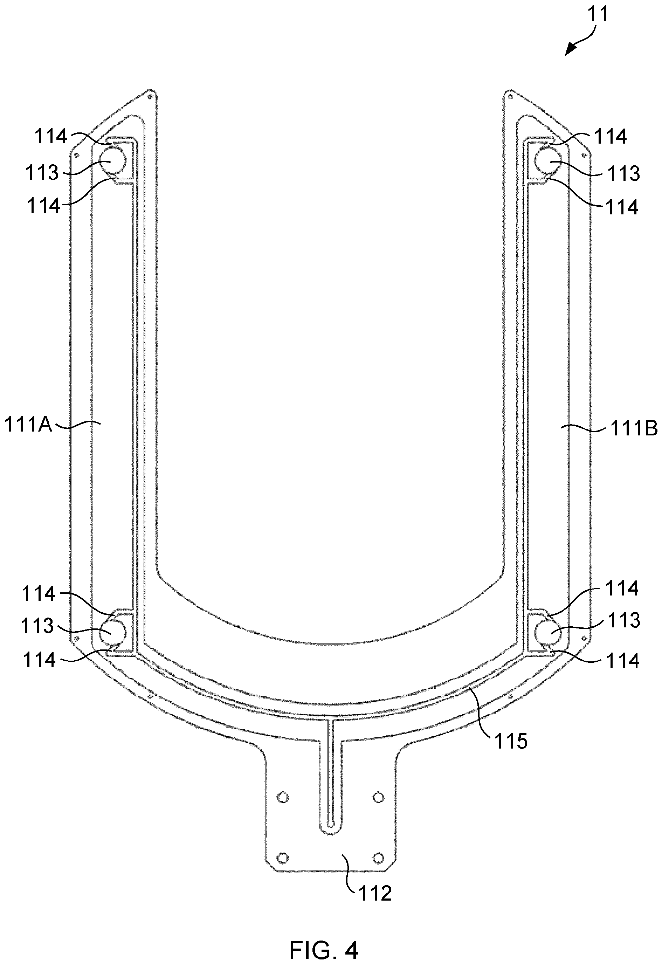

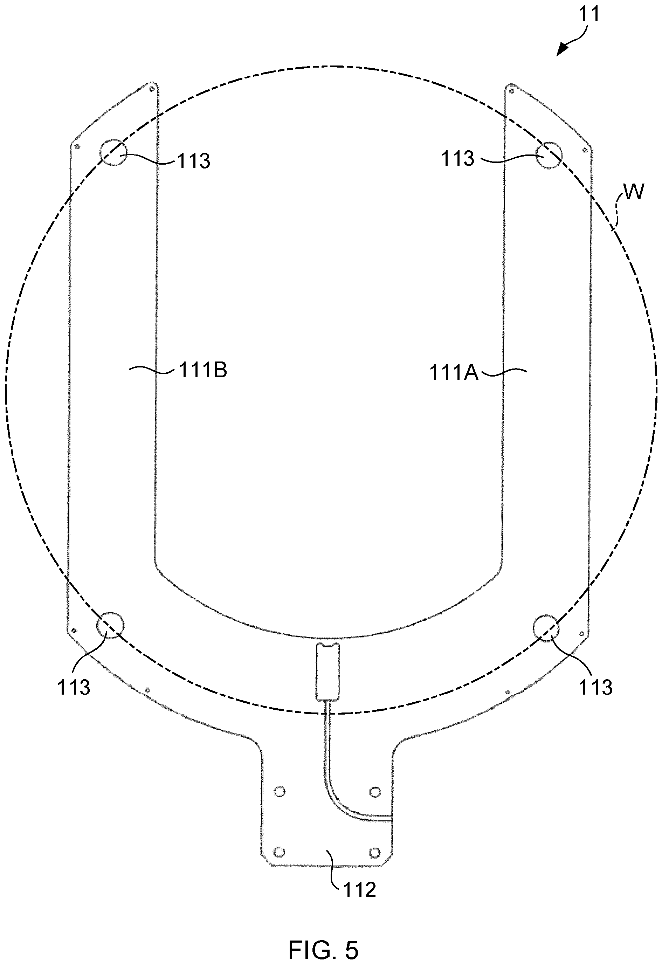

Figure 4 is a plan view of paddle 11, and Figure 5 is a bottom view of paddle 11. As shown in these figures, paddle 11 is a two-way fork-shaped plate, and comprises a pair of arms 111A and 111B, and connecting part 112. In the following description, if distinction need not be made between arms 111A and 111B, they will be referred to collectively as "arms 111."

Arms 111A and 111B are substantially rectangular in shape, and have leading and trailing edges that are arc-shaped. Arms 111A and 111B have through holes 113 at their leading and trailing edges. Through hole 113 is circular in shape. At the leading edges of arms 111A and 111B, through holes 113 are positioned in opposing relation to face each other in the left and right directions as shown in the figure. Similarly, at the trailing edges of arms 111A and 111B through holes 113 are positioned in opposing relation to each other in the left and right directions as shown in the figure. Arms 111A and 111B have a total of four through holes 113 arranged circumferentially to face the outer edge of wafer W to be conveyed. Each of through holes 113 forms concave part 15, described below, when a portion thereof is covered by sealing member 12.

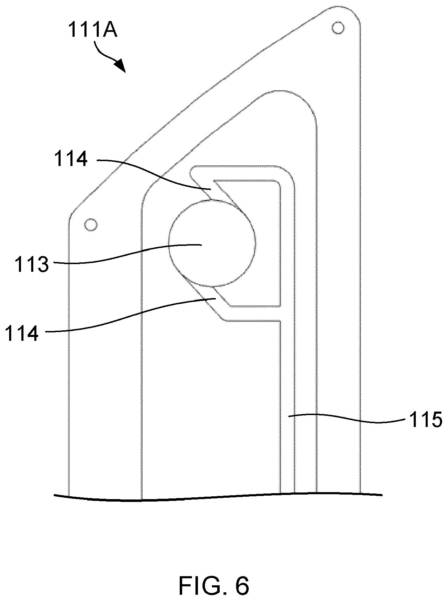

Discharge grooves 114 are formed on the top surface of arms 111A and 111B, and each are connected to one of through holes 113. Figure 6 is a top view of a leading edge of arm 111A. As shown in Figure 6, two discharge grooves 114 extend tangentially to the circumference of the outer edge of through hole 113. The two discharge grooves 114 are positioned point symmetrical relative to the center of through hole 113, and are covered by sealing member 12 to form a pair of discharge channels 16, described below.

As shown in Figures 4 and 5, connecting part 112 is generally T-shaped, and connects a pair of arms 111A and 111B.

As shown in Figure 4, supply groove 115 is formed on the top surface of connecting part 112 and a pair of arms 111A and 111B. Supply groove 115 has a two-way forked-shape, and is covered by sealing member 12 to form supply channel 17 (not shown in Figure 4). Supply channel 17 connects supply port 121 (see Figure 1) and each of discharge channels 16, and guides air supplied via supply port 121 to each of discharge channels 16.

The foregoing is a description of paddle 11.

Sealing member 12 will now be described. As shown in Figure 1, sealing member 12 is a two-way fork-shaped plate. Sealing member 12 is mounted to the top of paddle 11, and covers through holes 113, discharge grooves 114 and supply groove 115 of paddle 11 to form supply channel 17. Together with paddle 11, sealing member 12 forms the main body of the device.

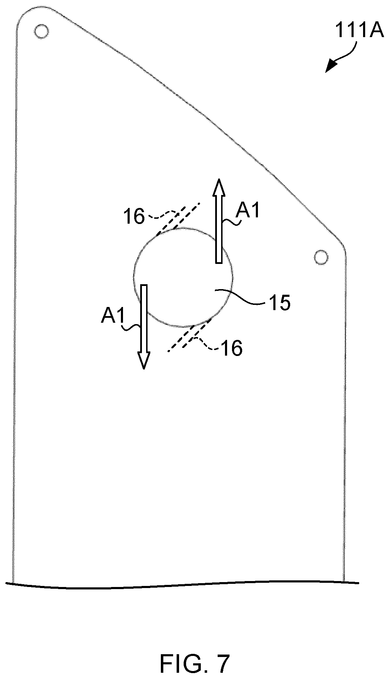

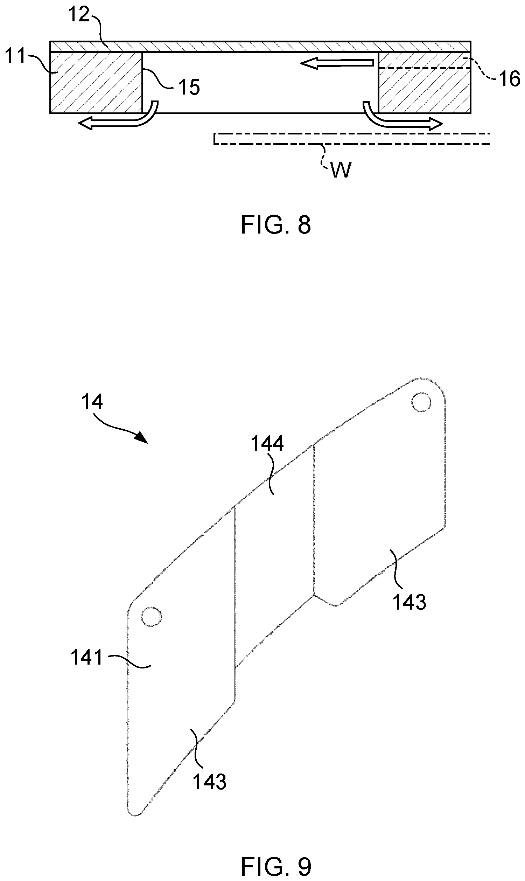

Figure 7 is a bottom view of the leading edge of arm 111Awith sealing member 12 attached. Figure 8 is a cross-section view of concave part 15 shown in Figure 7. As shown in Figures 7 and 8, concave part 15 is connected to a pair of discharge channels 16. The pair of discharge channels 16 extend tangentially to the circular outer edge of concave part 15, and are located point symmetrical relative to the circular center of the outer edge of concave part 15. The pair of discharge channels 16 are passageways through which air is discharged into concave part 15.

Air discharged into concave part 15 through discharge channels 16 is guided by the inner wall of concave part 15 to form a swirling flow, and flows out of concave part 15. When air is discharged into concave part 15, if wafer W faces the opening of concave part 15, wafer W restricts a flow of external air into concave part 15. Under such a condition, centrifugal forces and entrainment of the swirling flow result in a smaller density of fluid molecules per unit volume in the center of the swirling flow. Consequently, a negative pressure is generated within the center of the swirling flow. As a result, wafer W is subject to a pressure of surrounding air and is suctioned toward concave part 15. As wafer W approaches concave part 15, an amount of air flowing out of concave part 15 is reduced. As a result, the negative pressure generated within the center of the swirling flow decreases, and wafer W is supported by the surrounding air to maintain a distance from concave part 15.

The pair of discharge channels 16 are positioned so that air flowing out of concave part 15 flows in the longitudinal direction of arms 111, as indicated by arrows A1 in Figure 7. The pair of discharge channels 16 are arranged to have a direction of extension that forms an angle of approximately 45 degrees relative to the longitudinal direction of arm 111A. One of the pair of discharge channels 16 is positioned so that outflow air flows toward the leading edge of arm 111A, and the other of the pair of discharge channels 16 is positioned so that outflow air flows toward the trailing edge of arm 111A. Each of arrows A1 in Figure 7 shows a direction of a composite of flow velocity vectors of fluid molecules flowing out of concave part 15 after discharge from each of the pair of discharge channels 16 into concave part 15.

The direction of air flowing out of concave part 15 varies dependent on a flow rate of air discharged into concave part 15. Consequently, a direction in which each of discharge channels 16 extends can be adjusted so that outflow air flows toward the leading edge or trailing edge of arm 111A based on an optimal air flow rate discharged into concave part 15.

Sealing member 12 will now be further described. As shown in Figure 1, sealing member 12 has circular shaped supply port 121. A tube extending from an air pump (not shown in Figure 1) is connected to supply port 121, and air is supplied to wafer conveyance hand 1 from the air pump via supply port 121.

The foregoing is a description of sealing member 12.

Sensor 13 will now be described. As shown in Figure 2, sensor 13 is attached to the bottom of paddle 11. Sensor 13 is a proximity sensor that detects a presence or absence of wafer W.

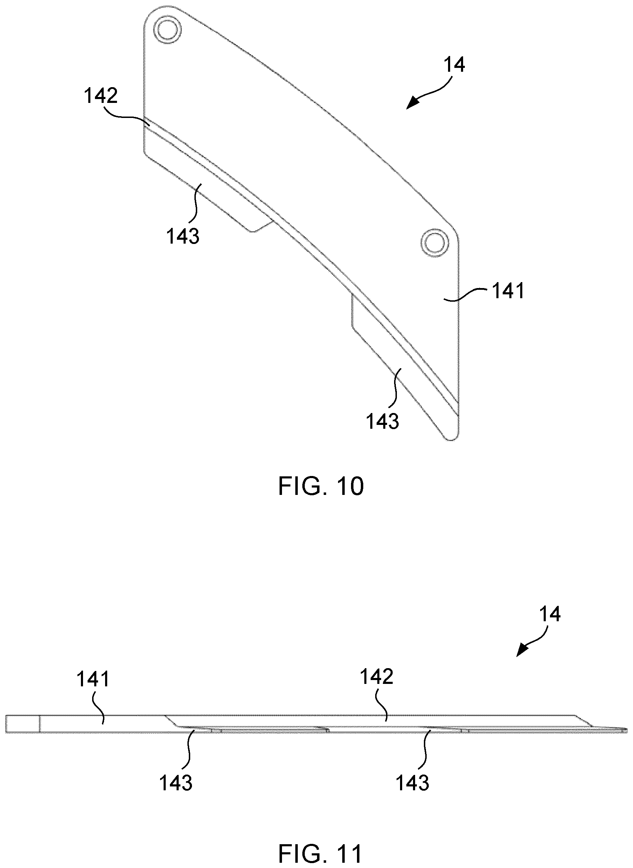

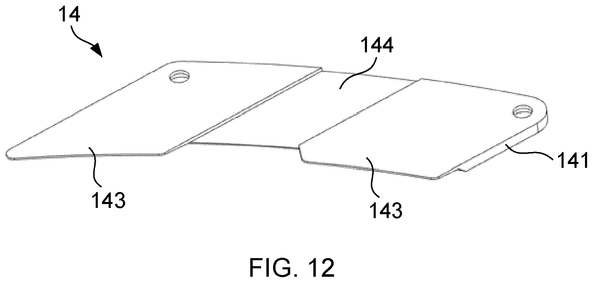

Guide members 14 will now be described. As shown in Figure 2, wafer conveyance hand 1 has four guide members 14. Figure 9 is a plan view of one of guide members 14; figure 10 is a bottom view of the one of guide members 14; figure 11 is a side view of the one of guide members 14; figure 12 is an oblique view of the one of guide members 14. As shown in these figures, guide member 14 is an arc-shaped plate, and comprises a main portion 141, inclined portion 142 and protruding parts 143. Exhaust groove 144 is formed between protruding parts 143.

Main Portion 141 is an arc-shaped plate.

Inclined Portion 142 is continuous with the inner edge of main portion 141. Inclined Portion 142 forms a slope between main portion 141 and protruding parts 143, which have sloped bottom sides. Namely, a two-step slope is formed by inclined portion 142 and protruding parts 143.

Protruding parts 143 are each a substantially rectangular-shaped plate, and extend laterally from an inner side of main portion 141, such that the further away from main portion 141 that the protruding parts 143 extend the thinner they are to maintain therebetween a predetermined distance.

Viewed in cross section exhaust groove 144 is a U-shaped groove, and is formed on the top surface of main portion 141 to extend in the lateral direction of main portion 141.

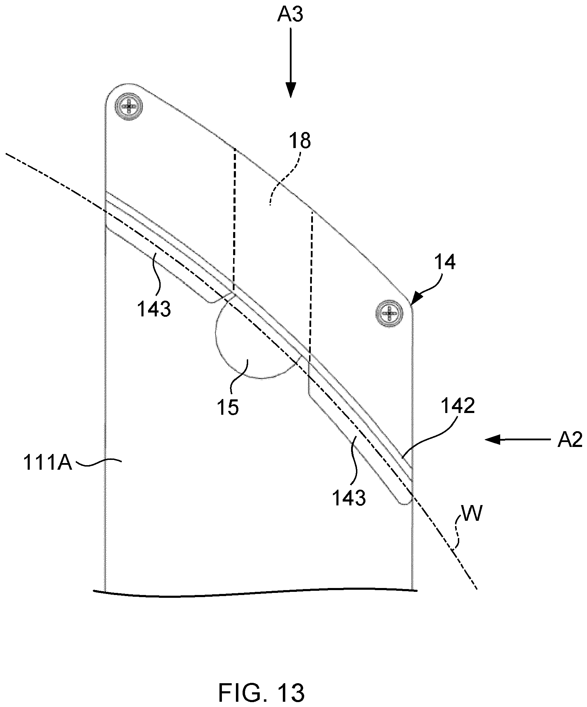

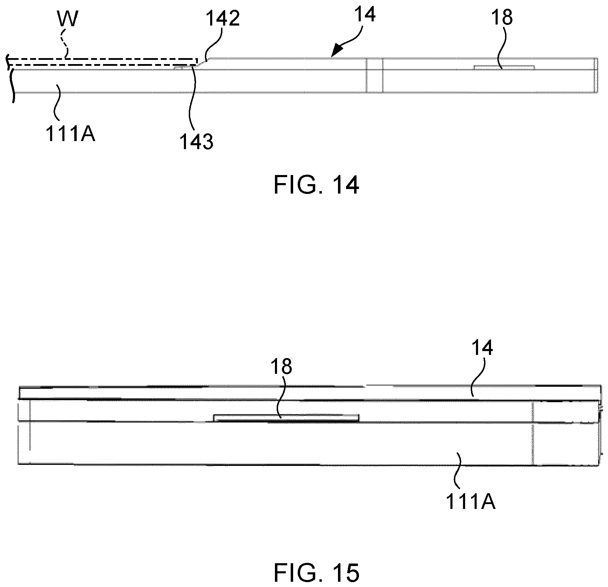

As shown in Figure 2, guide members 14 are each mounted to one each of the bottom of the leading edges and the bottom of the trailing edges of arms 111. Figure 13 is a bottom view of the leading edge of arm 111A, as shown in Figure 2. Figure 14 is a side view of the leading edge of arm 111Ain the direction indicated by arrow A2 as shown in Figure 13. Figure 15 is a side view of the leading edge of arm 111A along the direction indicated by arrow A3 as shown in Figure 13.

As shown in these figures, main portion 141 of guide member 14 mounted to arm 111A or 111B partially covers the opening of concave part 15. Specifically, guide member 14 covers a portion of the opening of concave part 15 that is not covered by wafer W to be conveyed. The slope formed by inclined portion 142 and protruding parts 143 of guide member 14 linearly contacts the outer edge of wafer W to be conveyed, and restricts horizontal movement of wafer W. The protruding parts 143 are configured to have concave part 15 between them, and guide a part of air flowing out of concave part 15 toward the center of arms 111. Exhaust groove 144 of guide member 14 forms exhaust channel 18 with the bottom surface of arms 111. Viewed in cross section, exhaust channel 18 is substantially rectangular, and extends in the longitudinal direction of arms 111. Exhaust channel 18 is a passageway used to exhaust outside of the device a part of air flowing out of concave part 15. Namely, exhaust channel 18 allows a part of air flowing out of concave part 15 to be exhausted in a direction from the inside of wafer W toward the outside of wafer W.

The foregoing is a description of guide members 14.

As shown in Figure 2, concave parts 15 of wafer conveyance hand 1 are positioned to face the outer edge of wafer W to be conveyed. Suction is applied by wafer conveyance hand 1 to only the outer edge of wafer W. The outer edge of wafer W is more rigid than its inner side, and thus damage to wafer W caused by suction by concave parts 15 is substantially obviated.

As shown in Figure 2, the portion of the opening of concave part 15 of wafer conveyance hand 1 that is not covered by wafer W to be conveyed is covered by guide member 14. Therefore, a flow of external air into concave part 15 is restricted. As a result, a decrease in negative pressure in concave part 15 caused by the inflow of external air is suppressed.

As shown in Figure 13, exhaust channel 18 is formed to be continuous with concave part 15. As described above, exhaust channel 18 exhausts to the outside of the device a part of air flowing out of concave part 15. Exhaust channel 18 allows outflow air to escape from the device, and prevents outflow air from remaining near concave part 15. As a result, a decrease in negative pressure generated in concave part 15 is suppressed.

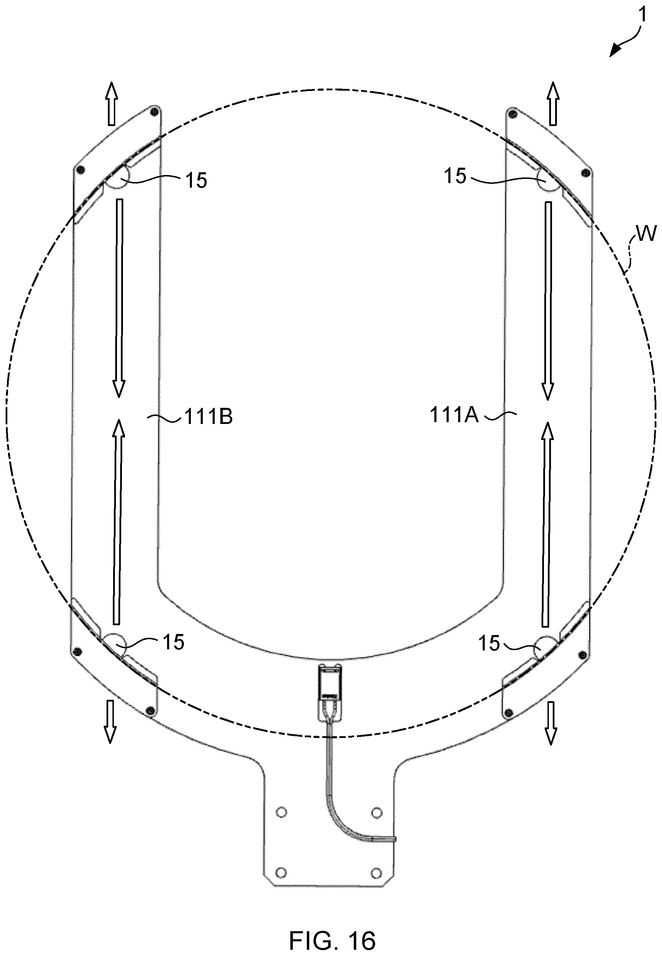

A part of air flowing out of concave part 15 flows in the longitudinal direction of arms 111. In other words, a part of air flowing out of concave part 15 flows from the outside to the inside of wafer W. Figure 16 illustrates air flow out of concave part 15. The arrows shown in Figure 16 illustrate air flow out of concave parts 15. More specifically, the arrows shown in Figure 16 indicate directions of the composite vector of flow velocity of fluid molecules discharged from discharge channels 16 and flowing out of concave part(s) 15. As shown in Figure 16, a part of air flowing out of concave part 15 flows in the longitudinal direction of arms 111. The air flowing toward the center collides with air flowing from the opposite direction resulting in turbulence, which acts downwardly on wafer W to be conveyed, and prevents wafer W to be conveyed from coming into contact with the bottom of arms 111.

### 2. Second Embodiment

Wafer conveyance hand 2 of the second embodiment of the present invention is described below with reference to the drawings.

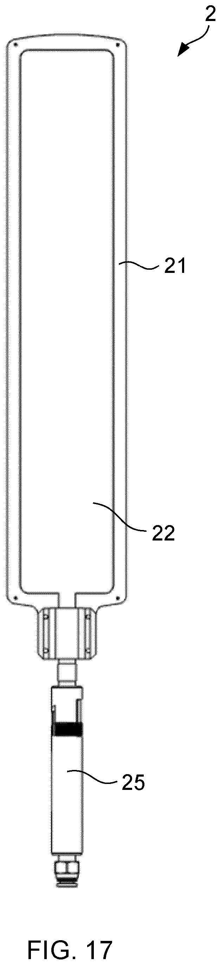

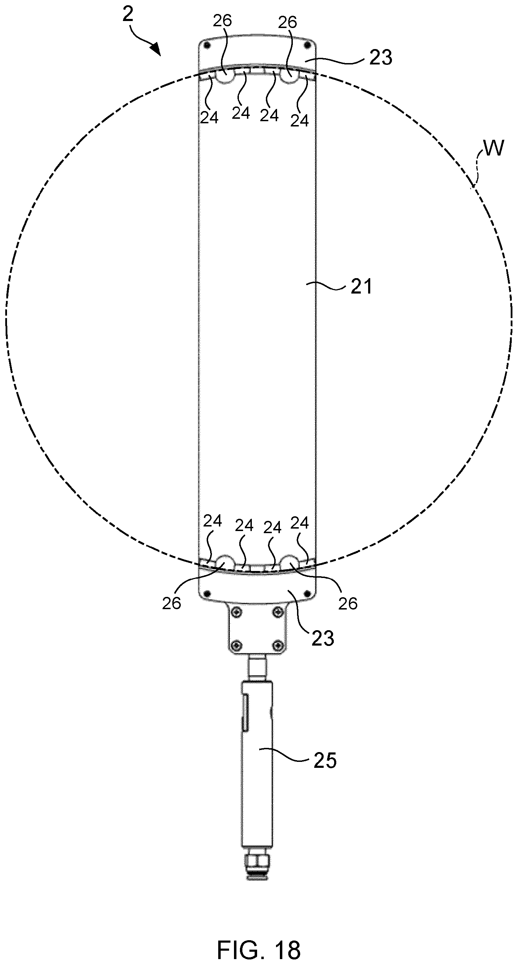

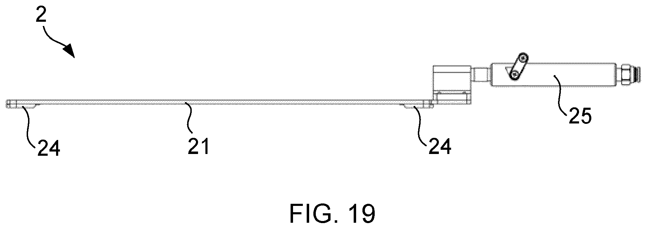

Figure 17 is a plan view of wafer conveyance hand 2. Figure 18 is a bottom view of wafer conveyance hand 2. Figure 19 is a side view of wafer conveyance hand 2. Wafer conveyance hand 2 shown in these figures is a device designed to apply suction to and convey wafer W by utilizing Bernoulli's law. Wafer conveyance hand 2 has grip 25, for use by an operator.

Wafer conveyance hand 2 comprises paddle 21, sealing member 22, guide members 23, cushioning members 24, and grip 25, which are described below.

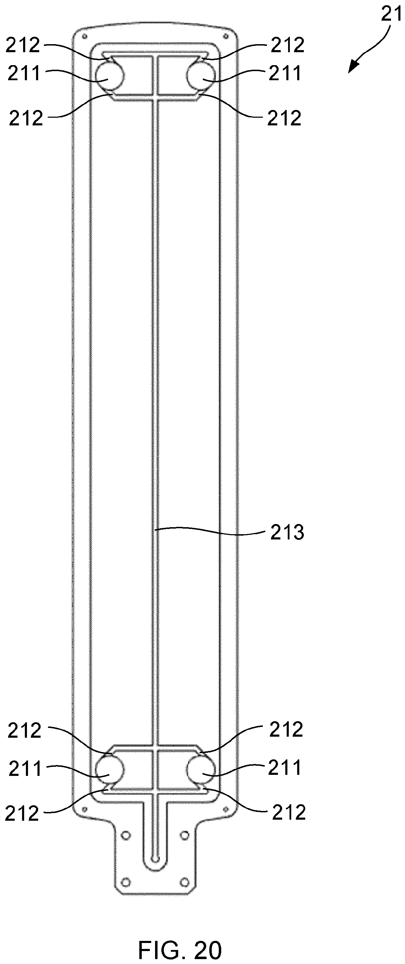

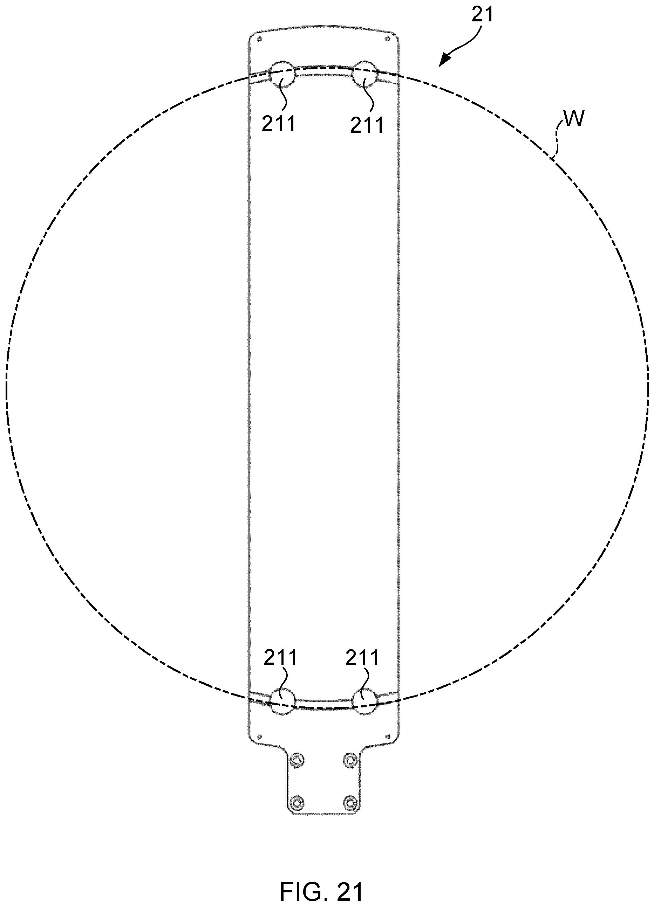

Figure 20 is a plan view of paddle 21, and Figure 21 is a bottom view of paddle 21. As shown in these figures, paddle 21 is a substantially rectangular-shaped plate, and has a pair of through holes 211 at each of its leading and trailing edges. The pair of through holes 211 at each of the leading and trailing edges of paddle 21 are positioned in opposing relation to face each other in the left and right directions as shown in Figure 20. Through hole 211 is circular in shape. A total of four through holes 211 are arranged circumferentially to face the outer edge of wafer W to be conveyed. Each of through holes 211 forms concave part 26, described below, when a portion thereof is covered by sealing member 22.

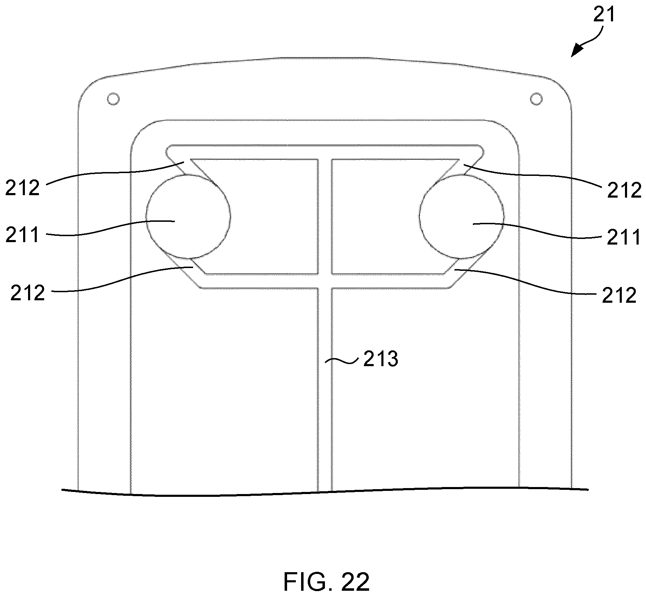

Four pairs of discharge grooves 212 are formed on the top surface of paddle 21, and each are connected to one of through holes 211. Figure 22 is a top view of a leading edge of paddle 21. As shown in Figure 22, two discharge grooves 212 extend tangentially to the circumference of the outer edge of through hole 211. The two discharge grooves 212 are positioned point symmetrical relative to the center of through hole 211, and are covered by sealing member 22 to form a pair of discharge channels 27, described below.

As shown in Figure 20, supply groove 213 is formed on the top surface of paddle 21, and supply groove 213 is covered by sealing member 22 to form supply channel 28 (not shown in Figure 20). Supply channel 28 connects Supplying port 221 (not shown in Figure 20) and each of discharge channels 27, and guides air supplied via supply port 221 to each of discharge channels 27.

The foregoing is a description of paddle 21.

Sealing member 22 will now be described. As shown in Figure 17, sealing member 22 is a plate that is substantially rectangular in shape. Sealing member 22 is mounted to the top of paddle 21. Sealing member 22 covers through holes 211, discharge grooves 212 and supply groove 213 of paddle 21 to form concave part 26, discharge channels 27 and supply channel 28. Together with paddle 21, sealing member 22, forms a main body of the device.

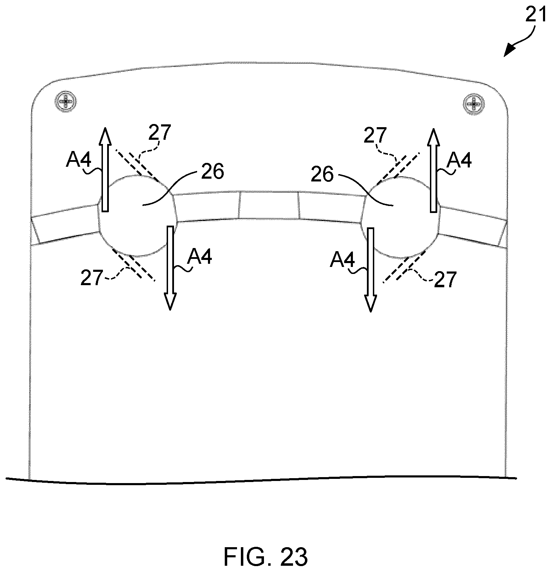

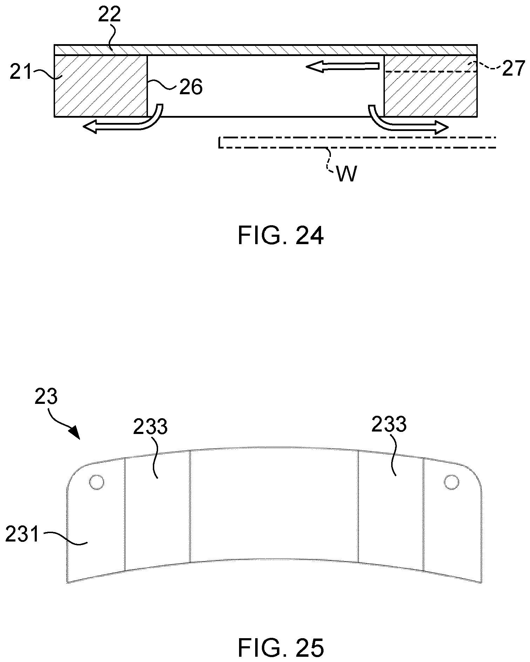

Figure 23 is a bottom view of the leading edge of paddle 21 with sealing member 22 attached. Figure 24 is a vertical cross-section view of concave part 26 shown in Figure 23. As shown in Figures 23 and 24, concave part 26 is connected to a pair of discharge channels 27. The pair of discharge channels 27 extend tangentially to the circumferential outer edge of concave part 26, and are located point symmetrical relative to the circular center of the outer edge of concave part 26. The pair of discharge channels 27 are passageways through which air is discharged into concave part 26.

Air discharged into concave part 26 through discharge channels 27 is guided by the inner wall of concave part 26 to form a swirling flow, and flows out of concave part 26. When air is discharged into concave part 26, if wafer W faces the opening of concave part 26, wafer W restricts a flow of external air into concave part 26. Under such a condition, centrifugal forces and entrainment of the swirling flow result in a smaller density of fluid molecules per unit volume in the center of the swirling flow. Consequently, a negative pressure is generated within the center of the swirling flow. As a result, wafer W is subject to a pressure of surrounding air and is suctioned toward concave part 26. As wafer W approaches concave part 26, an amount of air flowing out of concave part 26 is reduced. As a result, the negative pressure generated within the center of the swirling flow decreases, and wafer W is supported by the surrounding air to maintain a distance from concave part 26.

The pair of discharge channels 27 are positioned so that air flowing out of concave part 26 flows in the longitudinal direction of paddle 21, as indicated by arrows A4 in Figure 23. The pair of discharge channels 27 are arranged to have a direction of extension that forms an angle of approximately 45 degrees relative to the longitudinal direction of paddle 21. One of the pair of discharge channels 27 is positioned so that outflow air flows toward the leading edge of paddle 21, and the other of the pair of discharge channels 27 is positioned so that outflow air flows toward the trailing edge of paddle 21.

Each of arrows A4 in Figure 23 shows a direction of a direction of a composite of flow velocity vectors of fluid molecules flowing out of concave part 26 after discharge from each of the pair of discharge channels 27 into concave part 26.

The direction of air flowing out of concave part 26 varies dependent on a flow rate of air discharged into concave part 26. Consequently, a direction in which each of discharge channels 27 extends can be adjusted so that outflow air flows toward the leading edge or trailing edge of paddle 21 based on an optimal air flow rate discharged into concave part 26.

Sealing member 22 will now be further described. Sealing member 22 has circular shaped supply port 221 (not shown in Figures 17, 18 and 21) at its trailing edge whose shape is circular. Supplying port 221 is connected to a fluid passage (not shown in Figures 17, 18, and 21) formed inside grip 25.

The foregoing is a description of sealing member 22.

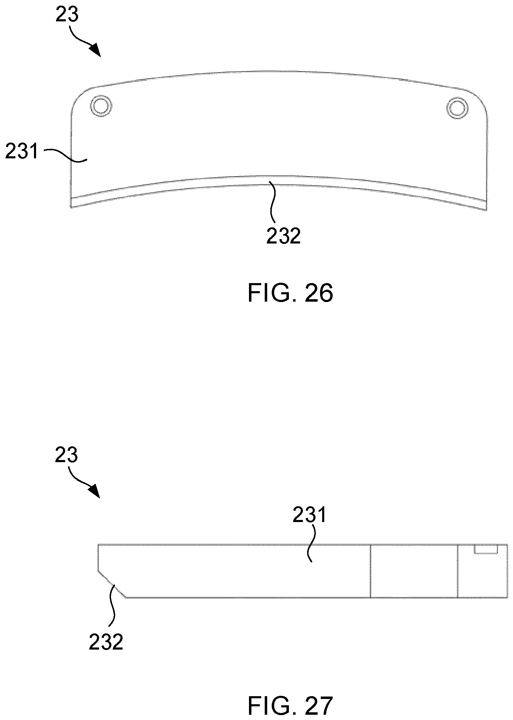

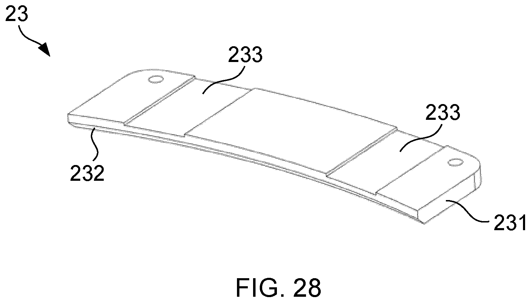

Guide members 23 will now be described. As shown in Figure 18, wafer conveyance hand 2 has two guide members 23. Figure 25 is a plan view of one of guide member 23;figure 26 is a bottom view of the one of guide members 23; figure 27 is a side view of the one of guide members 23; figure 28 is an oblique view of the one of the guide members 23. As shown in these figures, guide member 23 is an arc-shaped plate, and comprises main portion 231 and inclined portion 232. Two exhaust grooves 233 are formed on the top of main portion 231.

Main portion 231 is an arc-shaped plate.

Inclined portion 232 is continuous with the inner edge of main portion 231.

As viewed in cross section, each of exhaust grooves 233 is U-shaped, and is formed on the top surface of main portion 231 to extend laterally from main portion 23.

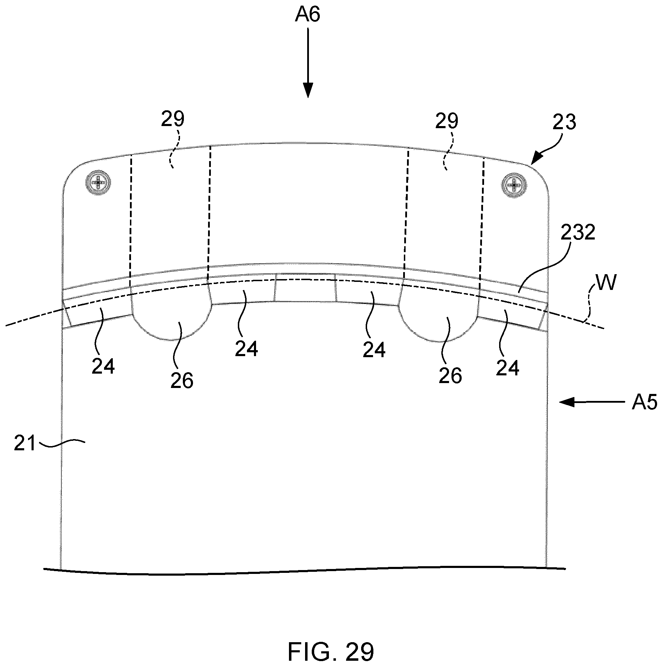

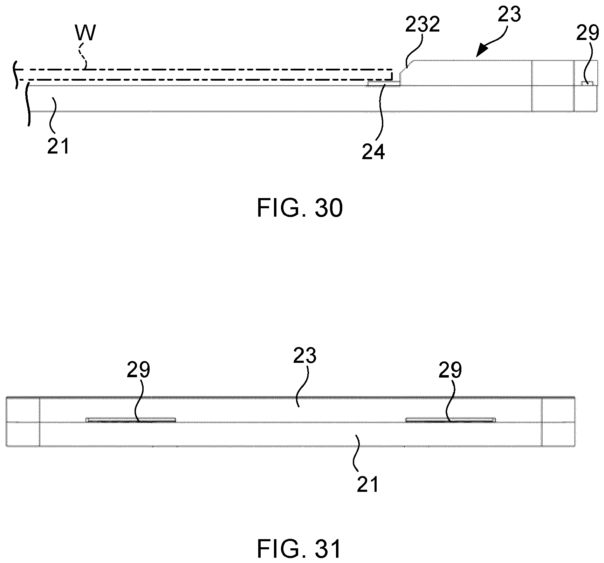

As shown in Figure 18, guide members 23 are each mounted to one each of the bottom of the leading edges and the bottom of the trailing edges of paddle 21. Figure 29 is a bottom view of the leading edge of paddle 21, as shown in Figure 18. Figure 30 is a side view of the leading edge of paddle 21 in the direction indicated by arrow A5, as shown in Figure 29. Figure 31 is a side view of the leading edge of paddle 21 in the direction indicated by arrow A6, as shown in Figure 29.

As shown in these figures, main portion 231 of guide member 23 mounted to paddle 21 partially covers the opening of concave part 26. Specifically, guide member 23 covers a portion of the opening of concave part 26 that is not covered by wafer W to be conveyed. The inner circumferential side of main portion 231 contacts the outer edge of wafer W to be conveyed and restricts horizontal movement of wafer W. Two exhaust grooves 233 of guide member 23 form two exhaust channels 29 with the bottom surface of paddle 21. Viewed in cross section, each of exhaust channels 29 is substantially rectangular. Each of exhaust channels 29 extends in the longitudinal direction of paddle 21. Exhaust channels 29 are passageways used to exhaust outside of the device a part of air flowing out of concave part 26. Namely, exhaust channels 29 allow a part of air flowing out of concave part 26 to be exhausted in a direction from the inside of wafer W toward the outside of wafer W.

The foregoing is a description of guide members 23.

Cushioning member 24 will now be described. Wafer conveyance hand 2 has eight cushioning members 24. Each of cushioning members 24 is a resin plate of substantially rectangular shape. As shown in Figure 29, four cushioning members 24 are mounted to an inside surface each of guide members 23. Two of four cushioning members 24 are positioned across one concave part 26. Cushioning members 24 guide a part of air flowing out of concave parts 26 to flow toward the center in the longitudinal direction of paddle 21. As shown in Figure 30, cushioning members 24 make contact with the outer edge of wafer W and restrict horizontal movement of wafer W under a resulting frictional force.

Grip 25 will now be described. Grip 25 is a hollow rod-shaped member. One end of grip 25 is connected to the top of the trailing end of paddle 21, and the other end of grip 25 is connected to a tube extending from an air pump (not shown in Figure 17). Air is supplied to supply channel 28 from the air pump via grip 25 and supply port 221.

As shown in Figure 18, concave parts 26 of wafer conveyance hand 2 are positioned to face the outer edge of wafer W to be conveyed, and only the outer edge of wafer W is subject to suction by wafer conveyance hand 2. The outer edge of wafer W is more rigid than its inner side. Therefore, damage to wafer W caused by suction by concave parts 26 is substantially reduced.

As shown in Figure 18, the portions of the openings of concave parts 26 of wafer conveyance hand 2 that are not covered by wafer W to be conveyed are covered by guide members 23. Therefore, a flow of external air into concave parts 26 is restricted. As a result, a decrease in negative pressure in each of concave parts 26 caused by the inflow of external air is suppressed.

As shown in Figure 29, exhaust channels 29 are formed to be continuous with concave parts 26. As described above, exhaust channels 29 exhaust to the outside of the device a part of air flowing out of concave parts 26. Exhaust channels 29 allow the outflow air to escape from the device, and prevent outflow air from remaining near concave parts 26. As a result, a decrease in negative pressure generated in each of concave parts 26 is suppressed.

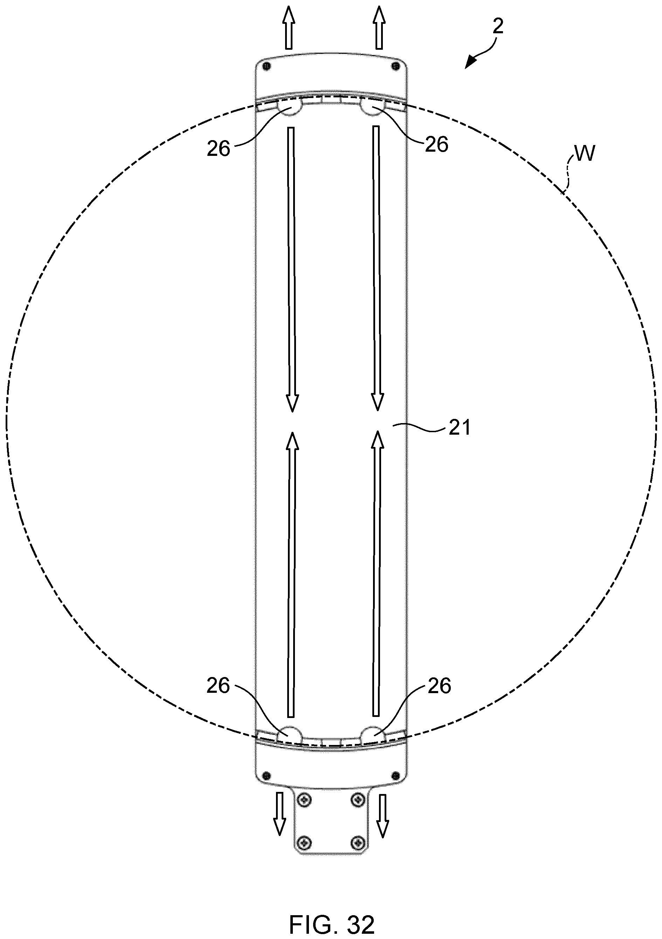

A part of air flowing out of concave parts 26 flows toward the center in the longitudinal direction of paddle 21. In other words, a part of air flowing out of each of concave parts 26 flows from the outside to the inside of wafer W. Figure 32 illustrates air flow out of concave parts 26.

The arrows shown in Figure 32 illustrates air flows out of concave parts 26. More specifically, the arrows shown in Figure 32 indicate directions of the composite vector of flow velocity of fluid molecules discharged from discharge channels 27 and flowing out of concave parts 26. As shown in Figure 32, a part of air flowing out of each of concave parts 26 flows toward the center in the longitudinal direction of paddle 21. The air flowing toward the center collides with air flowing from the opposite direction resulting in turbulence, which acts downwardly on wafer W to be conveyed, and prevents wafer W from coming into contact with the bottom of paddle 21.

### 3. Modifications

The embodiments described above may be modified as described below. It is of note that two or more of the modifications described below may be combined.

### 3-1. Modification 1

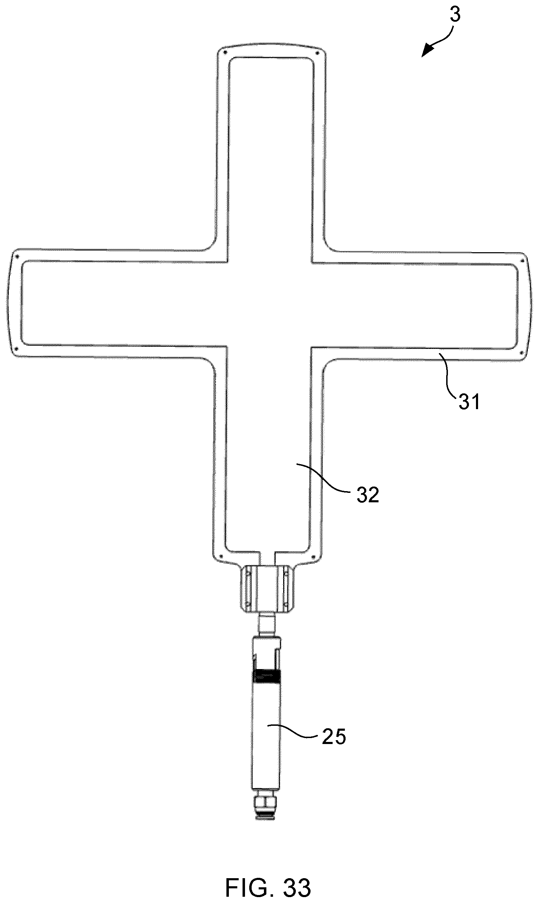

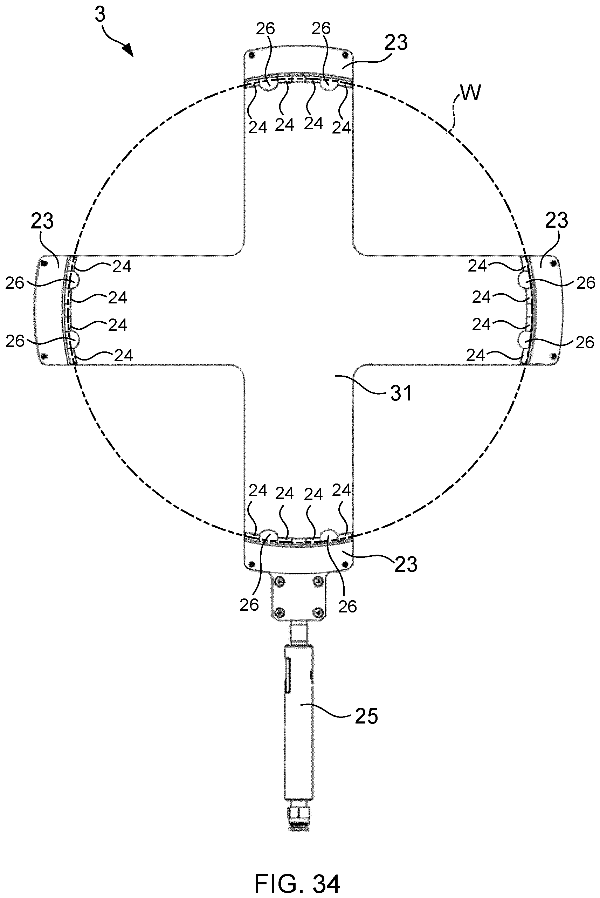

Wafer conveyance hand 2 of the second embodiment has paddle 21 and sealing member 22, each of which are I-shaped. The shapes of paddle 21 and sealing member 22 may be changed. Figure 33 is a plan view of wafer conveyance hand 3 that has paddle 31 and sealing member 32 whose shapes are cruciform instead of the I-shape of paddle 21 and sealing member 22. Figure 34 is a bottom view of wafer conveyance hand 3. As shown in Figure 34, wafer conveyance hand 3 has one pair of concave parts 26, four discharge channels 27 (not shown in Figure 34), guide member 23, and four cushioning members 24 at each of four edges of the main body which are composed of paddle 31and sealing member 32.

### 3-2. Modification 2

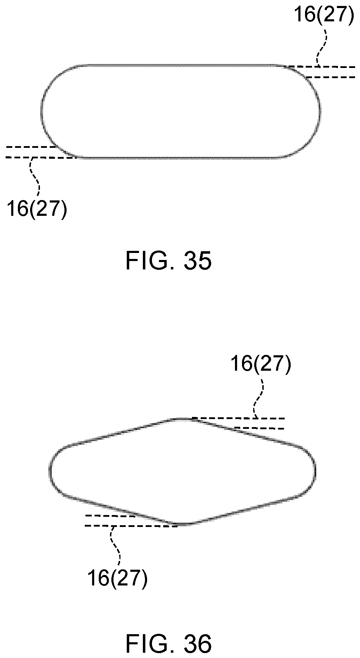

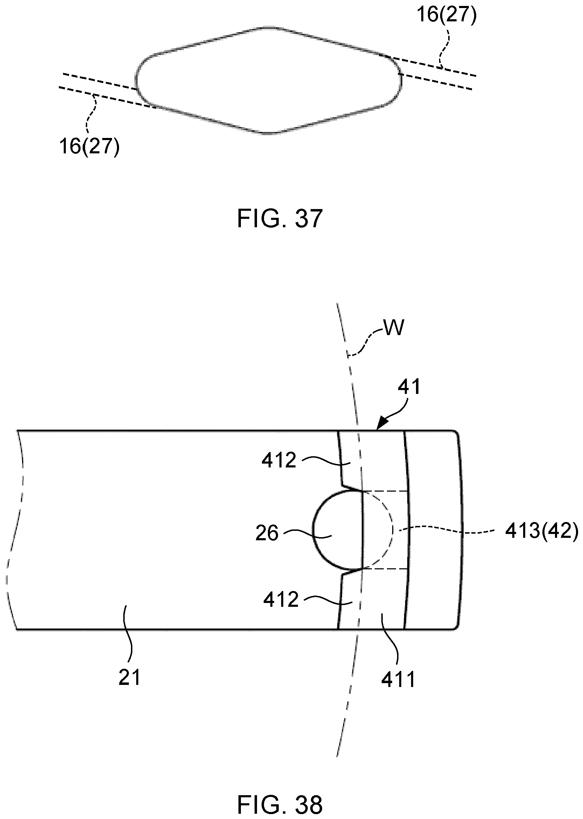

The shape of through holes 113 and 211 is not limited to circular. For example, the shape of through hole 113 or 211 may be elliptical shape as shown in Figure 35, diamond shape as shown in Figures 36 and 37, etc.

### 3-3. Modification 3

The numbers of guide members 14, concave parts 15, discharge channels 16 and exhaust channels 18 of wafer conveyance hand 1 may be changed according to the size of wafer W to be conveyed. Similarly, the numbers of guide members 23, concave parts 26, discharge channels 27 and exhausting channels 29 of wafer conveyance hand 2 may be changed according to the size of wafer W to be conveyed.

### 3-4. Modification 4

Paddle 11, sealing member 12 and four guide members 14 of wafer conveyance hand 1 may be molded as one piece. Similarly, paddle 21, sealing member 22, two guide members 23 and eight cushioning members 24 of wafer conveyance hand 2 may be molded as one piece.

### 3-5. Modification 5

The object conveyed by wafer conveyance hand 1 or 2 is not limited to a TAIKO wafer W. Wafer conveyance hand 1 or 2 may convey a plate-shaped object other than a TAIKO wafer W.

### 3-6. Modification 6

The fluid used to convey wafer W is not limited to a gas such as air, and liquid may be used to convey wafer W.

### 3-7. Modification 7

Wafer conveyance hand 2 need not comprise cushioning member 24, and only guide members 23 may be used to restrict horizontal movement of wafer W.

### 3-8. Modification 8

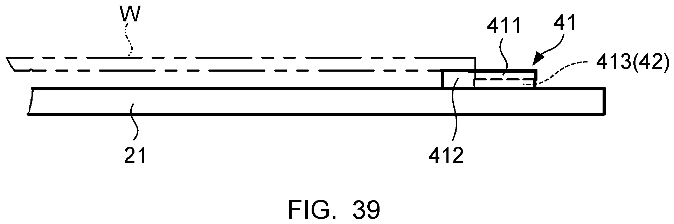

In the second embodiment described above, a part of the opening of concave part 26 of wafer conveyance hand 2 is covered by guide member 23. Instead of guide member 23, a part of the opening of concave part 26 may be covered by cushioning member 41 that restricts horizontal movement of wafer W. Figure 38 is a bottom view of cushioning member 41 according to this modification. Figure 39 is a side view of cushioning member 41. Cushioning member 41 shown in these figures is an arc-shaped resin plate. Cushioning member 41 consists of main portion 411, two protruding portions 412 and exhaust groove 413.

### Main portion 411 is an arc-shaped plate.

Each of protruding portions 412 is a substantially rectangular- shaped plate. Protruding portions 412 are formed from the inside surface of main portion 411 and extends laterally in the direction of main portion 411.

Exhaust groove 413 has a U-shaped cross-section. Exhaust groove 413 is formed on the top surface of main portion 411, and extends laterally in the direction of main portion 411.

Main portion 411 of cushioning member 41 mounted to paddle 21 partially covers the opening of concave part 26. Specifically, cushioning member 41 covers a portion of the opening of concave part 26 that is not covered by wafer W to be conveyed. Two protruding portions 412 of cushioning member 41 come into contact with the outer edge of wafer W to be conveyed and restrict horizontal movement of wafer W. Protruding portions 412 are positioned across concave part 26, and guide a part of air flowing out of concave part 26 toward the center in the longitudinal direction of paddle 21. Exhaust grooves 413 of guide member 41 form exhaust channel 42 with the bottom surface of paddle 21. As viewed in cross section, exhaust channel 42 is rectangular-shaped. Exhaust channel 42 extends in the longitudinal direction of paddle 21, and is a passageway for exhausting to outside of the device a part of air flowing out of concave part 26.

### 3-9. Modification 9

The shape of main portion 141 or 231 is not limited to an arc-shape, and it may be configured as appropriate depending on a shape of the plate-shaped object to be conveyed.

### 3-10. Modification 10

One or more grooves may be formed on the bottom of arms 111 of wafer conveyance hand 1 to guide a part of air flowing out of concave part 15 to the center in the longitudinal direction of arms 111. Air guided by the one or more grooves flows between arms 111 and wafer W, thereby separating wafer W from arms 111.

Similarly, one or more grooves may be formed on the bottom of paddle 21 of wafer conveyance hand 2 to guide a part of air flowing out of concave part 26 to the center in the longitudinal direction of paddle 21. Air guided by the one or more grooves flows between paddle 21 and wafer W, thereby separating wafer W from paddle 21.

### DESCRIPTION OF REFERENCE NUMERALS

1, 2, 3: wafer conveyance hand
11, 21 ,31: paddle
12, 22, 32: sealing member
13: sensor
14, 23: guide member
15, 26: concave part
16, 27: discharge channel
17, 28: supply channel
18, 29, 42: exhaust channel
24, 41: cushioning member
25: grip
111A, 111B: arm
112: connecting part
113, 211: through hole
114, 212: discharge groove
115, 213: supply groove
121, 221: supply port
141, 231: main portion
142, 232: inclined portion
143, 412: protruding portion
144, 233, 413: exhaust groove
411: main portion
W: wafer

## Claims

1. A conveyance device that applies suction to and conveys a plate-shaped object to be conveyed, the device comprising:
a plate-shaped main body that faces the plate-shaped object to be conveyed;
a plurality of recesses formed in the plate-shaped main body to face an outer circumferential portion of the plate-shaped object to be conveyed;
a plurality of discharge channels formed inside the plate-shaped main body; and
a plurality of movement restriction members formed on the main body to contact with and restrict lateral movement of the plate-shaped object to be conveyed;
wherein
one each of the plurality of discharge channels is connected to one each of the plurality of recesses, and a swirling flow is formed in the plurality of recesses with fluid supplied from the plurality of connected discharge channels; and
in each of the plurality of recesses, a portion of an opening not covered by the plate-shaped object to be conveyed is covered by one of the plurality of movement restriction members.

2. The conveyance device according to Claim 1, wherein
the plurality of recesses are formed at each of one end and another end of the main body in opposing relation to each other; and
the plurality of discharge channels are formed so that fluid flowing out of the plurality of recesses connected to the plurality of discharge channels flows in a direction from outside to inside of the plate-shaped object to be conveyed.

3. The conveyance device according to Claim 1 or 2, wherein
the plurality of movement restriction members each forms an outlet path between the plate-shaped main body such that fluid flowing out of any one of the plurality of recesses whose opening is partially covered by any one of the plurality of movement restriction members flows in the direction from the inside to the outside of the plate-shaped object to be conveyed.
